Europäisches Patentamt

European Patent Office

Office européen des brevets

(19)

(11) Publication number: **0 675 213 A1**

# EUROPEAN PATENT APPLICATION

(12)

(21) Application number: **95104662.2**

(22) Date of filing: **29.03.95**

(51) Int. Cl.⁶: **C25D 1/04**, H05K 1/09

(30) Priority: **31.03.94 JP 83801/94**

(43) Date of publication of application:
**04.10.95 Bulletin 95/40**

(84) Designated Contracting States:
**DE FR GB LU**

(71) Applicant: **MITSUI MININGS & MELTING CO., LTD.**
**1-1, 2-chome,**
**Nihombashi-Muromachi**
**Chuo-ku,**
**Tokyo (JP)**

(72) Inventor: **Saida, Muneo**

**13-4, 2-chome,**
**Kamiuma**
**Setagaya-ku,**
**Tokyo (JP)**
Inventor: **Hirasawa, Yutaka**
**923-40, Kamihideya**
**Okegawa-shi,**
**Saitama (JP)**

(74) Representative: **Grünecker, Kinkeldey,**
**Stockmair & Schwanhäusser**
**Anwaltssozietät**
**Maximilianstrasse 58**
**D-80538 München (DE)**

(54) **Electrolytic copper foil for printed wiring boards and process for producing the same.**

(57) An electrolytic copper foil for printed wiring boards which is characterized in that a ratio (orientation index) between a proportion of the peak value of X-ray diffraction intensity at the (111)-plane of the copper foil to the sum of all the peak values for the electrolytic copper foil, the diffraction intensity being measured from the electrolysis end surface thereof, to a proportion of the peak values of X-ray diffraction intensity at the (111)-plane to the sum of all the peak values for pure copper powder from the ASTM card, is in the range of from 0.5 to 1.0, and that a ratio (orientation index) at the (220)-plane obtained in the same manner as above is in the range of from 1.0 to 5.0; and a process for producing said electrolytic copper foil.

FIG. 1

EP 0 675 213 A1

## BACKGROUND OF THE INVENTION

1. Field of the Invention

The present invention relates to an electrolytic copper foil for printed wiring boards and to a process for producing the same. More specifically, the invention relates to an electrolytic copper foil for printed wiring boards which is made to have a fine crystal organization substantially free of orientation throughout the electrolytic copper foil (from the electrolysis start surface to the electrolysis end surface thereof) thereby to improve the electrolytic copper foil in etching characteristics, as well as to a process for producing the same.

2. Prior Art

To produce a copper foil in the prior art, in general, a direct current is supplied to between an insoluble metal anode and a metal cathode with a specularly polished surface while passing an electrolyte therebetween, to deposit copper on the surface of the cathode and continuously peel the deposited copper foil therefrom.

The cathode has a cylindrical shape and is installed so that it rotates while partly immersed in the electrolyte, and a copper foil of a predetermined thickness can be obtained by controlling the speed of rotation.

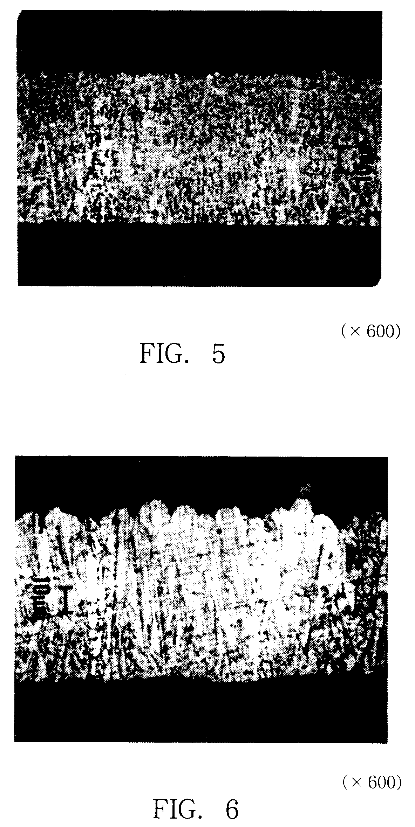

The side (electrolysis start surface) of the obtained copper foil, which faced to the cathode during electrolysis, is a shiny surface with smoothness, whereas the opposite side (electrolysis end surface) is a mat surface with ruggedness. This is because, as the electrodeposition advances, the columnar structure develops due to crystal orientation, and the grain size of the crystal increases. Fig. 6 shows an electron micrograph of the cross section of the metal structure of a conventional electrolytic copper foil.

The copper foil used for the printed wiring boards is usually adhered at its electrolysis end surface to a substrate to form a laminate, while its electrolysis start surface which is the front surface of a laminate, is coated with an etching resist of a desired pattern and then the undesired copper portions are removed by etching using an etching solution such as a copper chloride solution, thereby to obtain a circuit pattern. Whether the etching for forming the circuit pattern is good or not is usually determined based upon the rate of etching and the amount of undercut.

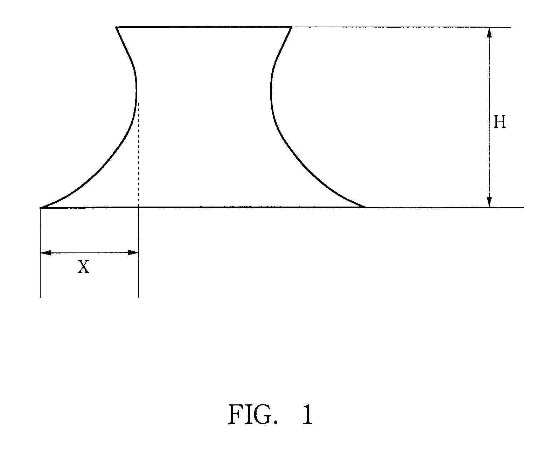

As shown in Fig. 6, the crystal structure of a conventional copper foil used for the printed wiring boards is characterized by the columnar structure which grows in the direction of thickness of the foil, and the grain size thereof gradually increasing from the electrolysis start surface toward the electrolysis end surface. In producing a printed wiring board by etching a copper-clad laminate in which the copper is such an electrolytic copper foil, the present inventors found that such undercut easily takes place due to the aforementioned crystal orientation of the copper foil when the copper-clad laminate is etched starting from the electrolysis start surface side. It is presumed that when an oriented copper foil is etched undercut tends to develop easily since the etching proceeds along the interface of the crystal orientation. Here, the undercut stands for a phenomenon in which a circuit pattern formed by etching assumes a cross-sectional shape of which the central portion is recessed at the side faces as shown in Fig. 1. The undercut will vary depending upon the thickness of the copper foil and become larger as the copper foil increases in thickness. Generally, whether the etching characteristics are good or not are represented by a value (Ef: etching factor) obtained by dividing the thickness of the copper foil by the amount of undercut as shown in the following formula

$$Ef = \frac{H}{X}$$

wherein H is the thickness ($\mu$m) of an electrolytic copper foil, and X is the size ($\mu$m) of undercut.

The etching factor will increase with a decrease in the thickness of a copper foil. Therefore, the thickness of the copper foil has been decreased with the progress of fining a circuit, that is, fabricating a circuit in a fine pattern pitch. By the way, the most advanced technology such as TAB tapes or the like is attempting to fabricate a circuit having a circuit pattern pitch of 30 $\mu$m or smaller and a gap pitch of 30 $\mu$m or smaller. When the conventional electrolytic copper foil is used, however, the above circuit is not obtained unless the copper foil has a thickness less than 10 $\mu$m. Use of a copper foil having such a small thickness, however, will cause the copper foil to be creased thereby to raise a problem from the standpoint of handling.

2

## SUMMARY OF THE INVENTION

The object of the present invention is to provide an electrolytic copper for printed wiring boards which has good etching characteristics suited for preparing circuit patterns, good yield strength and elongation percentage and an electrolysis end surface of little roughness, and overcomes the conventional technical problems, as well as to provide a process for producing the same.

In carrying out a step of etching for forming a circuit pattern of an electrolytic copper foil, the present inventors found that the amount of undercut and the rate of etching vary depending upon the orientation of the copper foil. The present inventors further found that the copper foil which is little oriented exhibits favorable etching characteristics, very high yield strength as compared with that of conventional electrolytic copper foils, a high elongation percentage at elevated temperature and an electrolysis end surface having decreased ruggedness. The present invention is based on these findings.

That is, the present invention resides in an electrolytic copper foil for printed wiring boards which is characterized in that a ratio (orientation index) between a proportion of the peak value of X-ray diffraction intensity at the (111)-plane of the copper foil to the sum of all the peak values for the electrolytic copper foil measured from an electrolysis end surface thereof and a proportion of the peak value of X-ray diffraction intensity at the (111)-plane to the sum of all the peak values for pure copper powder obtained from the ASTM card, is indicated by the following formula

$$
OI(111) = \frac{\text{sample } [P(111)]/ \Sigma \text{ sample } [P(111) + P(200) + P(220) + P(311)]}{\text{ASTM } [P(111)]/ \Sigma \text{ ASTM } [P(111) + P(200) + P(220) + P(311)]}
$$

which ranges from 0.5 to 1.0, and that a ratio (orientation index) at the (220)-plane obtained in the same manner as above is indicated by the following formula

$$
OI(220) = \frac{\text{sample } [P(220)]/ \Sigma \text{ sample } [P(111) + P(200) + P(220) + P(311)]}{\text{ASTM } [P(220)]/ \Sigma \text{ ASTM } [P(111) + P(200) + P(220) + P(311)]}
$$

which ranges from 1.0 to 5.0.

The magnitude of orientation of the crystal organization or structure of the electrolytic copper foil can be expressed by an orientation index (OI). In particular, the magnitude of orientation of the crystal structure of the electrolytic copper foil can be determined based upon the orientation indexes at the (111)-plane and at the (220)-plane.

The crystal structure is non-oriented when the orientation index of peak values of the electrolytic copper foil is 1.0, and whether the orientation index becomes greater or smaller than 1.0, the orientation of the crystal structure increases. The orientation index at the (111)-plane is 1.0 when the crystal structure is non-oriented and approaches 0 as the orientation of the crystal structure becomes more intense. On the other hand, the orientation index at the (220)-plane is 1.0 when the crystal structure is non-oriented and increases as the orientation of the crystal structure becomes more intense.

In the electrolytic copper foil of the present invention, the orientation index (OI) at the (111)-plane must be from 0.5 to 1.0, and the orientation index (OI) at the (220)-plane must be from 1.0 to 5.0.

According to the present invention as described above, undercut has little tendency to take place since the crystal structure of the electrolytic copper foil is little oriented. Moreover, the crystal grain size is small since the orientation is small. Furthermore, the rate of etching increases with a decrease in crystal grain size. Besides, the copper foil of this invention exhibits a very high yield strength and a large elongation percentage at elevated temperature (in an atmosphere of 180°C) as compared with a conventional copper foil, and also exhibits decreased ruggedness at its electrolysis end surface.

On the other hand, when the orientation index of an electrolytic copper foil is smaller than 0.5 at its (111)-plane and the orientation index is greater than 5.0 at its (220)-plane, the crystal structure of the electrolytic copper foil is greatly oriented. When this electrolytic copper foil is etched, therefore, the etching proceeds along the interface of the structure and the undercut increases. Moreover, the rate of etching decreases since the crystal grain size is large. Accordingly, said electrolytic copper foil exhibits inferior etching characteristics.

Thus, the copper foil for the printed wiring boards of the present invention has a crystal structure different from that of the prior art one and exhibits excellent properties such as etching characteristics.

In the step of producing electrolytic copper foils, impurities are inevitably infiltrated to some extent into the electrolytic copper foil though the amount infiltrated may vary depending upon a material for the copper, water, qualities of the facilities, and the like used. The elements as the impurities in the electrolyte include silver ions, cadmium ions, manganese ions, aluminum ions, iron ions, antimony ions and bismuth ions. Specifically, other impurities such as lead ions, tin ions, chlorine ions, silicon ions, calcium ions and arsenic ions greatly contribute to the orientation. Permissible amounts are 5 ppm for lead ions, 10 ppm for tin ions, 5 ppm for chlorine ions, 20 ppm for silicon ions, 50 ppm for calcium ions, and 10 ppm for arsenic ions. When the above impurities are contained in amounts in excess of the permissible amounts, the precipitated copper foil obtained exhibits a fixed orientation. The other impurities should be contained in the electrolyte in as small amounts as possible, as a matter of course. The orientation is apt to take place easily when, for example, the amount of iron ions contained exceeds 2000 ppm.

In order to obtain the electrolytic copper foil of the present invention, the impurities in the electrolyte must be further limited. Concretely speaking, it is necessary to use an electrolyte which contains 3 ppm or less of lead ions, 6 ppm or less of tin ions, 2 ppm or less of chlorine ions, 15 ppm or less of silicon ions, 30 ppm or less of calcium ions, and 7 ppm or less of arsenic ions. When these impurities in the electrolyte exceed these values, it becomes impossible to obtain a fine and substantially orientation-free electrolytic copper foil of the present invention.

BRIEF DESCRIPTION OF THE DRAWINGS

Fig. 1 is a schematic diagram for explaining undercuts produced when a copper foil is etched;

Fig. 2 is a graph showing orientation indexes at the (111)-plane and (220)-plane respectively for the electrolysis start surfaces and the electrolysis end surfaces of electrolytic copper foils of Examples and Comparative Examples;

Fig. 3 is a graph showing X-ray diffraction images obtained by applying X-rays respectively to the electrolysis start surface and the electrolysis end surface of an electrolytic copper foil of Example 1;

Fig. 4 is a graph showing X-ray diffraction images obtained by applying X-rays respectively to the electrolysis start surface and the electrolysis end surface of an electrolytic copper foil of Comparative Example 3;

Fig. 5 is a metallurgical microphotograph ($\times 600$) of a cross section of the metal structure of an electrolytic copper foil of Example 3; and

Fig. 6 is a metallurgical microphotograph ($\times 600$) of a cross section of the metal structure of an electrolytic copper foil of Comparative Example 4.

DESCRIPTION OF THE PREFERRED EMBODIMENTS

The present invention will now be concretely described based upon Examples in comparison with Comparative Examples.

Example 1

A copper electrolyte having a copper ion concentration of 80 g/L and a sulfuric acid concentration of 150 g/L was prepared by using reagents, after which the electrolyte was adjusted so that it contained, as impurities, 3 ppm of lead ions, 6 ppm of tin ions, 2 ppm of chlorine ions, 15 ppm of silicon ions, 30 ppm of calcium ions and 7 ppm of arsenic ions, and electrolysis was then carried out at a cathode current density of 50 A/dm$^2$ in the thus adjusted electrolyte thereby to obtain an electrolytic copper foil having a thickness of 35 $\mu$m.

The electrolysis end surface of the copper foil was subjected to the same surface treatment (zinc plating or zinc alloy plating, chromate treatment, treatment with a silane coupling agent, etc.) as that of a usually used electrolytic copper foil, and was then adhered onto a glass epoxy substrate (an epoxy resin-impregnated glass fiber substrate) under heat and pressure to prepare a copper-clad laminate. Then, an etching resist of a desired pattern was applied onto the surface of the copper foil of the laminate and was etched with an etching solution of copper chloride to prepare a printed wiring board having a circuit pattern of a circuit width of 100 $\mu$m and a gap width of 100 $\mu$m.

Example 2

The procedure of Example 1 was followed except that the copper electrolyte containing said impurities of Example 1 was replaced by a copper electrolyte containing, as impurities, 3 ppm of lead ions, 6 ppm of tin ions, 2 ppm of chlorine ions, 15 ppm of silicon ions, 30 ppm of calcium ions, 7 ppm of arsenic ions and 2000 ppm of iron ions, thereby to obtain an electrolytic copper foil having a thickness of 35 $\mu$m.

By using this copper foil, a printed wiring board was prepared in quite the same manner as in Example 1.

Comparative Example 1

An electrolytic copper foil having a thickness of 35 $\mu$m was obtained by following the procedure of Example 1 except that the copper electrolyte of Example 1 was replaced by a copper electrolyte that contained, as impurities, 10 ppm of lead ions, 6 ppm of tin ions, 10 ppm of chlorine ions, 15 ppm of silicon ions, 30 ppm of calcium ions and 7 ppm of arsenic ions.

A printed wiring board was prepared from this copper foil in quite the same manner as in Example 1.

Comparative Example 2

The procedure of Example 1 was followed except that the copper electrolyte of Example 1 was replaced by a copper electrolyte containing, as impurities, 10 ppm of lead ions, 6 ppm of tin ions, 10 ppm of chlorine ions, 30 ppm of silicon ions, 80 ppm of calcium ions and 7 ppm of arsenic ions, thereby to obtain an electrolytic copper foil having a thickness of 35 $\mu$m.

By using this copper foil, a printed wiring board was prepared in quite the same manner as in Example 1.

Comparative Example 3

An electrolytic copper foil having a thickness of 35 $\mu$m was obtained in the same manner as in Example 1 but using a copper electrolyte that contained, as impurities, 10 ppm of lead ions, 15 ppm of tin ions, 10 ppm of chlorine ions, 30 ppm of silicon ions, 80 ppm of calcium ions and 30 ppm of arsenic ions.

By using this copper foil, a printed wiring board was prepared in quite the same manner as in Example 1.

The electrolytic copper foils obtained in Examples 1 and 2 and in Comparative Examples 1 to 3 were measured for their roughness of the electrolysis end surface, yield strength (at room temperature and elevated temperature) and elongation percentage (at room temperature and elevated temperature) and were further evaluated for their etching factor of the copper foil obtained by etching for preparing a circuit pattern. The results were as shown in Table 1. The roughness of the electrolysis end surface was measured in compliance with JIS B 0601. In Table 1, Ra represents an average roughness along the center line, Rmax represents a maximum height, and Rz represents an average roughness on an maximum of ten points. In Table 1, the yield strengths at elevated temperature and the elongation percentages at elevated temperature were measured in an atmosphere of 180°C.

Table 1

| Examples and Comp. Examples | Roughness of the electrolysis end surface (μm) | | | Yield strength (kg/mm²) | | Elongation percentage (%) | | Etching factor |
|---|---|---|---|---|---|---|---|---|
| | Ra | Rmax | Rz | room temp. | elevated temp. | room temp. | elevated temp. * | |
| Example 1 | 0.75 | 5.45 | 4.54 | 58.1 | 24.8 | 7.3 | 6.1 | 9 |
| Example 2 | 0.88 | 6.21 | 5.83 | 57.7 | 24.3 | 5.9 | 5.7 | 8 |
| Comp. Example 1 | 1.17 | 7.27 | 6.46 | 37.9 | 19.4 | 5.7 | 2.0 | 5 |
| Comp. Example 2 | 1.29 | 7.40 | 6.72 | 35.4 | 19.1 | 5.9 | 1.8 | 4 |
| Comp. Example 3 | 1.34 | 8.41 | 6.95 | 32.3 | 16.6 | 9.7 | 1.6 | 3 |

*: measured in an atmosphere of 180°C

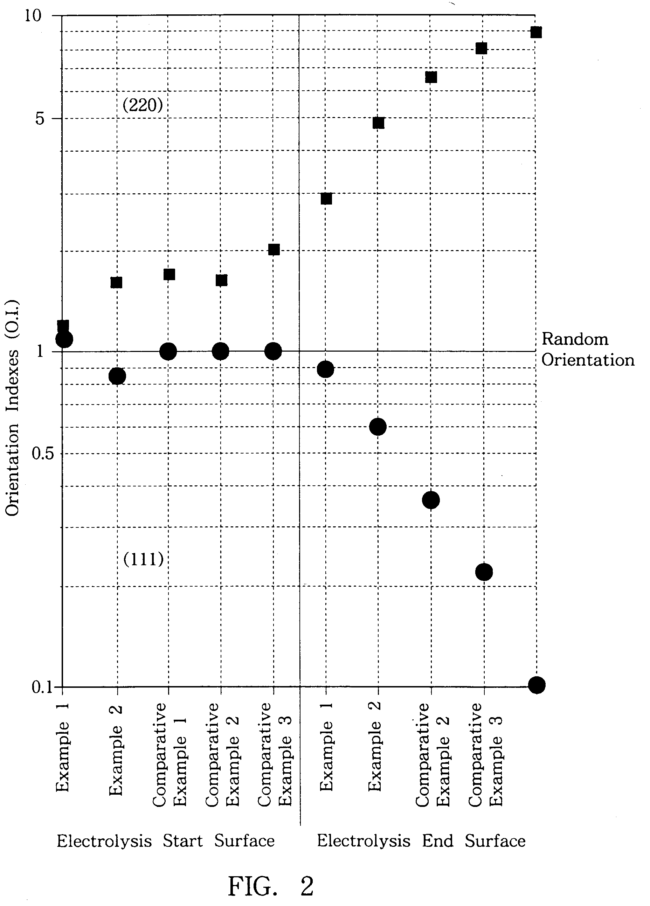

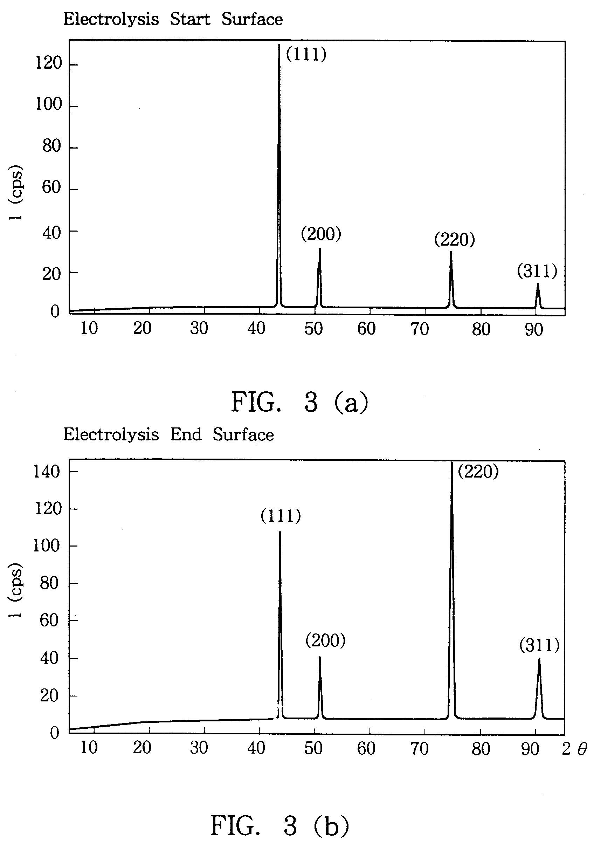

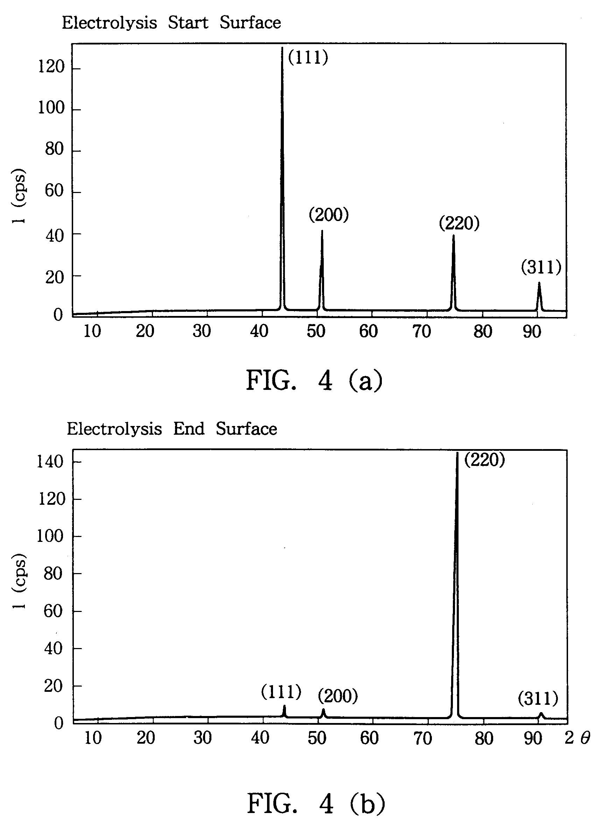

The electrolysis start surfaces and the electrolysis end surfaces of the electrolytic copper foils prepared in Examples 1 and 2 and in Comparative Examples 1 to 3 were subjected to X-ray diffraction analysis to find orientation indexes at the (111)-plane and at the (220)-plane. The results are as shown in Fig. 2. Figs. 3(a) and 3(b) and Figs. 4(a) and 4(b) show X-ray diffraction images for the electrolysis start surface and the electrolysis end surface of the electrolytic copper foils of Example 1 and Comparative Example 3.

Example 3

An electrolytic copper foil having a thickness of 70 μm was obtained in the same manner as in Example 1. Fig. 5 is a metallurgical microphotograph (×600) of a cross section of the metal structure of this metal foil.

Comparative Example 4

An electrolytic copper foil having a thickness of 70 μm was obtained in the same manner as in Comparative Example 3. Fig. 6 is a metallurgical microphotograph (×600) of a cross section of the metal structure of this metal foil.

The electrolytic copper foil of the present invention having a fine crystal structure substantially free of orientation, exhibits the following effects:

(1) When the copper foil of the present invention which is substantially free of orientation is used, undercut little develops during the etching for forming a circuit pattern.

(2) Since the copper foil is substantially free of orientation, the crystal grain size decreases and the rate of etching (amount of etching per unit time) for forming a circuit pattern increases.

(3) The roughness of the surface (electrolysis end surface) on which copper precipitation ended during electrolysis, becomes low due to the crystal structure being made fine.

(4) Due to the copper foil being made substantially free of orientation, the crystal grain size becomes small, the yield strength becomes high, and a sufficient elongation percentage at elevated temperature is realized.

(5) The use of the copper foil of the present invention makes it possible to form therefrom a circuit pattern having a pattern width of 30 μm or smaller and a gap width of 30 μm or smaller required for the most advanced technology such as a TAB tape even when said copper foil has a thickness of from 18 to 25 μm.

**Claims**

1. An electrolytic copper foil for printed wiring boards which is characterized in that a ratio (orientation index) between a proportion of the peak value of X-ray diffraction intensity at the (111)-plane of the copper foil to the sum of all the peak values for the electrolytic copper foil, the diffraction intensity being measured from the electrolysis end surface thereof, and a proportion of the peak values of X-ray diffraction intensity at the (111)-plane to the sum of all the peak values for pure copper powder obtained from the ASTM card, is indicated by the following formula

$$
OI(111) = \frac{sample\ [P(111)]/\ \Sigma\ sample\ [P(111)\ +\ P(200)\ +\ P(220)\ +\ P(311)]}{ASTM\ [P(111)]/\ \Sigma\ ASTM\ [P(111)\ +\ P(200)\ +\ P(220)\ +\ P(311)]}
$$

which ranges from 0.5 to 1.0, and that a ratio (orientation index) at the (220)-plane obtained in the same manner as above is indicated by the following formula

$$
OI(220) = \frac{sample\ [P(220)]/\ \Sigma\ sample\ [P(111)\ +\ P(200)\ +\ P(220)\ +\ P(311)]}{ASTM\ [P(220)]/\ \Sigma\ ASTM\ [P(111)\ +\ P(200)\ +\ P(220)\ +\ P(311)]}
$$

which ranges from 1.0 to 5.0.

2. A process for producing an electrolytic copper foil for printed wiring boards, characterized by using a copper electrolyte which is so controlled that it contains, as impurities, not more than 3 ppm of lead ion, not more than 6 ppm of tin ion, not more than 2 ppm of chlorine ion, not more than 15 ppm of silicon ion, not more than 30 ppm of calcium ion and not more than 7 ppm of arsenic ion.

FIG. 1

FIG. 2

Electrolysis Start Surface

FIG. 3 (a)

Electrolysis End Surface

FIG. 3 (b)

Electrolysis Start Surface

FIG. 4 (a)

Electrolysis End Surface

FIG. 4 (b)

(× 600)

FIG. 5

(× 600)

FIG. 6

European Patent

Office

EUROPEAN SEARCH REPORT

Application Number

EP 95 10 4662

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | US-A-5 181 770 (BROCK)<br><br>----- | | C25D1/04<br>H05K1/09 |

TECHNICAL FIELDS
SEARCHED (Int.Cl.6)

C25D
H05K

The present search report has been drawn up for all claims

| Place of search | Date of completion of the search | Examiner |
|---|---|---|
| THE HAGUE | 10 July 1995 | Nguyen The Nghiep, N |